Europäisches Patentamt

European Patent Office

Office européen des brevets

(11) Publication number: **0 112 675**
**B1**

(12) **EUROPEAN PATENT SPECIFICATION**

(45) Date of publication of patent specification: **01.04.87**

(51) Int. Cl.⁴: **H 01 L 23/52**

(21) Application number: **83307503.9**

(22) Date of filing: **09.12.83**

(54) A link structure selectively activable to create a conducting link in an integrated circuit.

(30) Priority: **28.12.82 JP 230100/82**

(43) Date of publication of application:
**04.07.84 Bulletin 84/27**

(45) Publication of the grant of the patent:
**01.04.87 Bulletin 87/14**

(84) Designated Contracting States:
**DE FR GB**

(56) References cited:
**DE-B-2 906 249**

**ELECTRONICS INTERNATIONAL, vol. 54, no.
15, July 1981, New York J.B. BRINTON "Laser
pulses form connections for system on a
wafer", pages 39-40**

**ELECTRONICS INTERNATIONAL
IBM TECHNICAL DISCLOSURE BULLETIN, vol.
24, no. 7ADecember 1981, New York R. CULLET
et al. "Programmable read-only memory
programmed by laser means", pages 3490-3491
IBM TECHNICAL DISCLOSURE BULLETIN**

(73) Proprietor: **FUJITSU LIMITED
1015, Kamikodanaka Nakahara-ku
Kawasaki-shi Kanagawa 211 (JP)**

(72) Inventor: **Mukai, Ryoichi c/o Fujitsu Limited
Patent Department 1015 Kamikodanaka
Nakahara-ku Kawasaki-shi Kanagawa 211 (JP)**

(74) Representative: **Sunderland, James Harry et al
HASELTINE LAKE & CO. Hazlitt House
28 Southampton Buildings Chancery Lane
London WC2A 1AT (GB)**

## Description

This invention relates to a method of fabricating a semiconductor device, and in particular concerns the provision of a structure for creating a conducting link in an integrated circuit (IC), for example in order to replace bad circuitry by spare circuitry fabricated in the IC die beforehand.

As the degree of integration of integrated circuits increases, the employment of redundancy techniques in the fabrication of such circuits has been discussed with regard to possible enhancement of manufacturing yield. Manufacturers are coming to a view that the use of redundancy techniques is acceptable and economically affordable.

A redundancy technique is implemented for example by providing memory chips (or dies) with spare rows or spare columns of circuitry. This can increase chip yield and provide improved process performance because bad circuitry can be replaced by spare circuitry.

Replacement of bad circuitry is effected by melting off a fuse connecting the bad circuitry within an integrated circuitry and creating conducting links to associated spare circuits.

Usually, such conducting links are created from non-conductive links linking specified points of associated spare circuits, by spot heating the non-conductive links to change them to conductive links when it is necessary to establish conductive connection.

A method of creating links is set forth, for example, in the report of 1981 IEEE International Solid State Circuit Conference, page 14, reported by O. Minato and others.

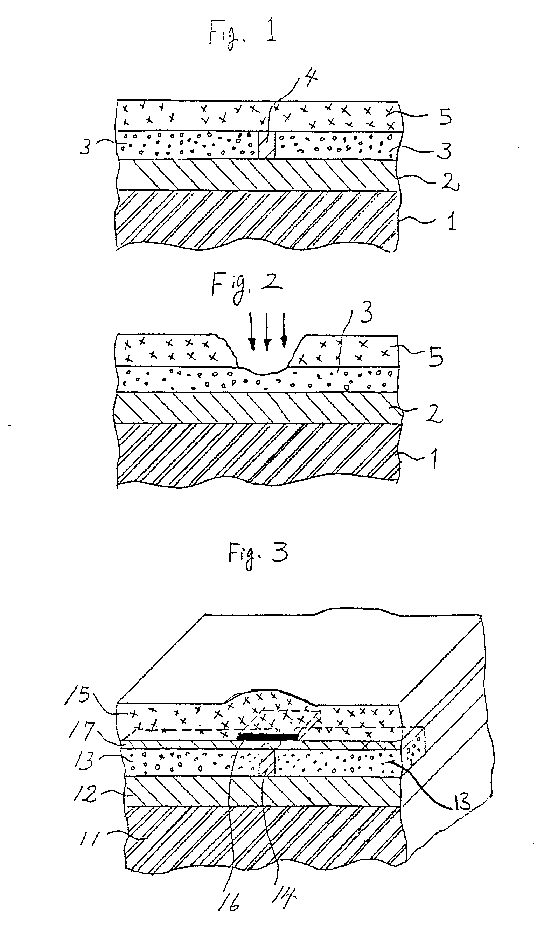

A proposed method of creating links is described below with reference to Figures 1 and 2 of the accompanying drawings which are respective sectional views.

Fig. 1 schematically illustrates a non-conducting link structure. On a silicon substrate 1, an insulating layer 2, for example of silicon dioxide ($SiO_2$), is fabricated. On that insulating layer 2, polycrystalline silicon (polysilicon) conducting path regions 3 which are highly doped with N-type dopant, such as phosphorus, are formed separated from one another by a non-doped polysilicon insulating gap 4 about 1 μm wide, having a resistivity of more than $10^9$ Ωcm. The path regions 3 and gap 4 are covered with a phospho-silicon glass (PSG) sealing layer 5, for surface protection and passivation.

When an electrically conductive link is required between the conducting paths 3, the insulating gap 4 is "activated" by laser irradiation. The irradiation portion of the insulating gap 4 is heated up to around 1400°C, and the dopant contained in conducting path regions 3 is diffused into the insulating gap 4, reducing its resistivity to $10^3$ Ωcm. Fig. 2 shows a conducting link formed by such an activation process.

However, some undesirable effects accompany the heating involved in the activation process described above. The heat generated by laser irradiation is transferred to neighbouring areas, and the characteristics of nearby semiconductor elements are affected as a result of re-arrangement of dopant. The surface of a conducting link where it is exposed (not covered by the sealing layer 5) is oxidised, and reliability thereby is reduced. Furthermore the PSG sealing layer 5 is also melted, creating a hole and making the surface of the layer rough. The rough surface collects dust and moisture and causes insulation problems.

In order to activate the link structure of Fig. 1, the temperature of the laser irradiated portion of the insulating gap must be high, up to around 1400°C, and a relatively high laser power is needed to achieve such high temperature. So long as the conducting link is created by diffusion of dopant into an insulating gap, such high temperature heating is inevitably needed.

Electronics International, Vol, 54, No. 15, July 1981, pages 39 and 40 (New York, U.S.A.) discloses the use of a laser beam for forcing contact between upper- and lower-level metallizations separated by a layer of sputtered amorphous silicon insulation. The laser beam is fired at a point where upper and lower metallizations cross each other.

According to the present invention there is provided a link structure, in an integrated circuit, in combination with conductive path regions in the integrated circuit which are electrically insulated from one another, which link structure is selectively activatable to provide a conductive link between the conductive path regions; characterised in that the link structure comprises

a highly resistive silicon insulating layer covering respective portions of the conductive path regions, and

a metal film on the silicon insulating layer so arranged that the silicon insulating layer can be caused chemically to react with the metal film to form a conductive metal silicide when the link structure is locally heated, thus to activate the link structure to provide the conductive link between the conductive path regions.

An embodiment of the present invention can provide a method for creating a conducting link in a semiconductor device, requiring only a low activation temperature, to avoid damage of semiconductor elements near a heat spot developed to cause activation.

An embodiment of the present invention can provide a method for creating a conducting link in a semiconductor device in which activation of the link can be accomplished without melting the PSG sealing layer.

An embodiment of the present invention can provide for activation to be accomplished with reduced laser power, to economise on the cost of a laser beam source.

Briefly, in an embodiment of the present invention, a link structure has a high resistivity polysilicon insulating layer which covers specified portions of conducting path regions (which regions are to be afforded the possibility of being electrically connected by a link formed when the link structure is activated). A metal layer, of either tungsten or molybdenum or the like, is provided over the non-doped polysilicon insulating layer.

The link structure is activated by chemical reaction between the metal layer and the polysilicon insulating layer to form a conductive layer of metal silicide. The resistivity of the metal silicide is low enough to afford a conductive link between the conducting path regions. Thus a conducting link is created.

For example a laser beam is used to heat up the link structure to activate the chemical reaction. The temperature required for the chemical reaction is much lower than the temperature required for dopant diffusion as described with reference to Fig. 2. In fact, the abovementioned chemical reaction occurs at around 500—700°C, and therefore the temperature required for activation is reduced to a great extent.

Reference is made, by way of example, to the accompanying drawings, in which:—

Fig. 1 is an enlarged sectional view illustrating a non-conducting link structure as previously proposed;

Fig. 2 is an enlarged sectional view showing the link of Fig. 1 made conducting after applying a laser beam as previously proposed;

Fig. 3 is an enlarged partially cut away view in perspective, of a link structure embodying the present invention; and

Figs. 4 to 9 are respective enlarged sectional views illustrating respective stages in the fabrication of a link structure embodying the present invention, Fig. 9 showing the link after activation.

The present invention is concerned with a selectively activatable link, that is, a link or "reverse fuse" which has a non-electrically conducting condition but which can be selectively activated to achieve an electrically conducting condition, thus to create a conductive link.

The structure of a link embodying the present invention, before activation — i.e. in a non-conductive condition — will be described with reference to Fig. 3.

In Fig. 3, 12 is an insulating layer, for example a silicon dioxide ($SiO_2$) layer, covering a semiconductor substrate 11, for example a silicon substrate.

On (in) the substrate 11, various circuit elements of an IC, such as transistors, diodes, resistors and so on, are fabricated, or are partly fabricated, but they are not shown in the Figure for the sake of simplicity.

Conducting path regions 13 are provided by a selectively doped polycrystalline silicon (polysilicon) layer of around 400 nm (4000 Å) thickness formed on the insulating layer 12. Resistivity of these path regions 13 is less than approximately $10^3$ Ωcm.

The conducting path regions 13 are insulated from one another by a narrow non-doped polysilicon insulating gap 14 of 1 to 1.5 μm width and resistivity of more than $10^9$ Ωcm.

Conducting path regions 13 and polysilicon insulating gap 14 are covered by a non-doped polysilicon insulating layer 17 around 50 nm (500 Å) thick.

A thin metal film 16, such as a film of molybdenum, tantalum, tungsten, titanium and platinum, 30 to 50 nm (300 to 500 Å) thick and 3 μm wide is deposited selectively over a specified portion of the layer 17. This metal film 16 covers the polysilicon insulating gap 14 and overlaps the conducting path regions 13. Thus, a link structure is provided, which in the non-activated condition of Fig. 3 is isolated from the conducting path regions 13 by the polysilicon insulating layer 17.

On the surface of the device, a sealing layer 15 is formed to protect the semiconductor surface. The sealing layer is made for example of phospho-silicate glass (PSG).

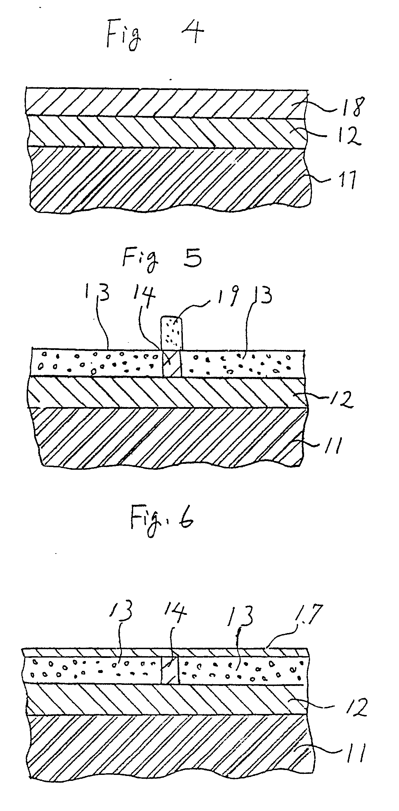

An example of processes for fabricating a link structure as shown in Fig. 3 will now be further described by reference to Figures 4 to 9. The processes are instituted at an appropriate stage in the normal IC fabrication procedure. Such procedure is not a direct concern of the present invention and thus it will not be explained in detail.

After circuit elements, such as transistors, diodes and so on have been fabricated, processes for establishing wiring between the elements commence. At this stage, some additional process steps are introduced to fabricate the link structure.

In Fig. 4, 11 is a silicon substrate, in which the aforementioned circuit elements have been fabricated. The elements are covered by an insulating layer 12, which is usually made of silicon dioxide ($SiO_2$) film. This insulating layer can be formed by a conventional process used in IC fabrication, such as sputtering or chemical vapour deposition (CVD) and so on.

A polysilicon insulating layer 18 is formed on the insulating layer 12 by a conventional CVD method. The polysilicon insulating layer 18 will normally be provided with a resistivity of more than $10^9$ Ωcm.

As can be seen in Fig. 5, after the formation of polysilicon insulating layer 18, a photo-resist pattern 19 is formed on the layer 18 except on parts of the layer 18 which are to provide conducting path regions, using conventional photo-lithographic techniques.

Next, dopants such as arsenic, phosphorus, boron and so on are ion-implanted into polysilicon insulating layer 18 parts which are not covered by the photo-resist pattern 19. For example, a high dose of arsenic, approximately $10^{15}$ ions/cm³, is implanted. Conducting path regions 13, having a resistivity of around $10^3$ Ωcm, are thus formed.

Between the conducting path regions 13 there remains a polysilicon insulating gap 14 of 1 to 1.5 μm width.

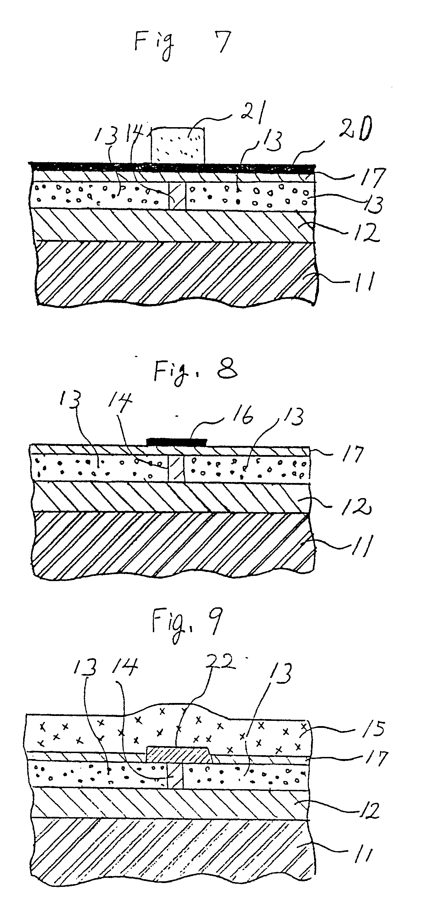

Following the ion-implantation of dopant, remaining photo-resist 19 is removed and a non-doped polysilicon insulating layer 17 of about 50 nm (500 Å) thickness is grown by a CVD method as shown in Fig. 6.

Then, a thin molybdenum metal film 20 of 30 to 50 nm (300 to 500 Å) thickness is formed over the substrate insulating layer 17 by sputtering, as seen in Fig. 7.

As shown in Fig. 7, a photo-resist pattern 21 is then formed on the molybdenum film 20 in a region where the link structure is to be provided.

The molybdenum metal film 20 exposed beyond (uncovered by) the photo-resist pattern 21 is etched off by a conventional chemical etching method and there is thus formed a metal layer 16 as shown in Fig. 8. In this case the layer 17 is shown to be significantly more extensive than the metal layer 16, but this may not be so (so long as portions of the conductive path regions 13 are overlapped).

The additional process steps, additional to otherwise necessary IC fabrication steps, involved in fabricating a link structure are concluded by the abovementioned etching step. Ordinary IC fabrication procedures are then resumed.

As a final process step, a phospho-silicate glass (PSG) layer 15 is formed, by a CVD technique, over the surface of the substrate. (Layer 15 can be seen in Fig. 9).

The link structure is provided by metal layer 16 and the polysilicon insulating layer 17 as shown in Fig. 3. In the state shown the link is not conductive because conducting path regions 13 and metal layer 16 are insulated from one another by polysilicon insulating layer 17. A method of making this link conductive (activation) will now be described.

If a need arises to electrically connect conducting path regions 13 associated with a specified link, it is necessary to activate the link structure to make it conductive.

In order to do this, the link is heated up to temperature at which the metal layer 16 and polysilicon insulating layer 17 react with one another to form a conductive layer of metal silicide. The temperature needed is much lower than the 1400°C which is necessary for activating a link by diffusion of dopant into polysilicon conducting paths as explained with reference to Figs. 1 and 2.

Spot heating by laser beam irradiation is suitable for activating the link as shown in Fig. 3. A laser beam can be focussed to a fine spot and can be controlled easily and precisely. The beam can also penetrate through PSG layer 15 without suffering up (rupturing or breaking) the layer 15.

Where molybdenum and silicon are used in the link structure, heating to 550°C will activate the link by creating a molybdenum silicide layer 22 as shown in Fig. 9 bridging the two conducting path regions 13. The resistivity of the silicide layer 22 is $10^2$ Ωcm. This is sufficient to short circuit the conducting path regions 13 electrically. Thus, a conducting link is created.

As described above, a laser beam is used as a heating source for link activation. Beams such as ion beams and electron beams and so on can alternatively be used. Furthermore, materials other than molybdenum can be used for metal film 16. For example, tantalum, tungsten, titanium, platinum and so on can be used.

Various modifications of the above-described steps can be made.

For example, a non-doped amorphous silicon layer of high resistivity can be used in place of the polysilicon insulating layer 17.

As can be seen in above description, an embodiment of the present invention uses a low temperature chemical reaction to form metal silicide.

The heating power necessary to activate the link is decreased as compared with the proposal of Figs. 1 and 2, and there is no danger of damage to circuit element near a (laser) spot heated link. This provides for improved IC reliability.

Furthermore, the phospho-silicate glass layer 15 is not melted by laser beam heating of such power, so the surface of the device is kept smooth, eliminating problems such as poor electrical insulation.

It will be clear that the present invention concerning selectively activatable conducting links can be applied widely; not only to redundancy circuits in semiconductor memories, but also to circuits in programmable read only memories, master-slicing ICs and so on.

An embodiment of the invention affords a method of creating a conducting link or "reversed fuse" between conducting paths of semiconductor device at a specified portion in an IC.

A link structure is formed by a polysilicon insulating layer and a metal film formed on the polysilicon insulating layer. For activation of the link, the link structure is heated by laser beam and the polysilicon insulating layer and metal film react with one another to form a conducting layer of metal silicide to conductively link the conducting paths.

The activation is accomplished by a chemical reaction to form a metal-silicide. The activation temperature required is reduced to a large extent compared to that required for a previous link structure.

The lower activation temperature protects devices close to the heat spot. The surface of the substrate is not disrupted by high temperature and thus reliability is increased.

The material of the metal film may include at least one of molybdenum, tantalum, tungsten, titanium and platinum.

The polysilicon insulating layer may have a resistivity higher than $10^9$ Ωcm.

The metal silicide may have a resistivity lower than $10^2$ Ωcm.

The non-doped high resistivity polysilicon insulating layer may be replaced by a non-doped high resistive amorphous silicon insulating layer covering said specified portion of said conducting paths to be linked.

## Claims

1. A link structure, in an integrated circuit, in combination with conductive path regions (13) in the integrated circuit which are electrically insulated from one another, which link structure is selectively activable to provide a conductive link between the conductive path regions; characterised in that the link structure comprises:

a highly resistive silicon insulating layer (17) covering respective portions of the conductive path regions (13), and

a metal film (16) on the silicon insulating layer, so arranged that the silicon insulating layer can be caused chemically to react with the metal film to form a conductive metal silicide when the link structure is locally heated, thus to activate the link structure to provide the conductive link between the conductive path regions.

2. A link structure in combination with the conductive path regions, as claimed in claim 1, wherein the metal film includes at least one of the metals molybdenum, tantalum, tungsten, titanium, platinum.

3. A link structure in combination with the conductive path regions as claimed in claim 1 or 2, such that the metal silicide (22) formed upon activation of the link structure has a resistivity of $10^2$ $\Omega$cm or less.

4. A link structure in combination with the conductive path regions as claimed in any preceding claim, wherein the silicon insulating layer (17) is a non-doped polysilicon layer.

5. A link structure in combination with the conductive path regions as claimed in claim 1, 2 or 3, wherein the silicon insulating layer (17) is a non-doped amorphous silicon layer.

6. A link structure in combination with the conductive path regions as claimed in any preceding claim, wherein the silicon insulating layer (17) has a resistivity of $10^9$ $\Omega$cm or greater.

7. A link structure in combination with the conductive path regions as claimed in any preceding claim, activable by heating through irradiation by an electron beam, an ion beam, or a laser beam.

8. A link structure in combination with the conductive path regions as claimed in claim 7, activable by heating to a temperature in the range 500°C to 700°C.

9. An integrated circuit having electrically isolated spare circuitry, provided with a link structure in combination with the conductive path regions as claimed in any one of claims 1 to 8 selectively activable to provide an electrical connection to the spare circuitry.

## Patentansprüche

1. Verbindungsstruktur in einer integrierten Schaltung, in Verbindung mit leitenden Wegbereichen (13) in der integrierten Schaltung, die elektrisch voneinander isoliert sind, welche Verbindungsstruktur wahlweise aktivierbar ist, um eine leitende Verbindung zwischen den leitenden Wegbereichen zu bilden, dadurch gekennzeichnet, daß die Verbindungsstruktur umfaßt:

eine isolierende Schicht (17) aus Silizium mit hohem Widerstand, die jeweilige Abschnitte der leitenden Wegbereiche (13) bedeckt, und

einen Metallfilm (16) auf der isolierenden Siliziumschicht, der so angeordnet ist, daß verursacht werden kann, daß die isolierende Siliziumschicht chemisch mit dem Metallfilm reagiert, um ein leitendes Metallsilicid zu bilden, wenn die Verbindungsstruktur lokal erhitzt wird, um so die Verbindungsstruktur zu aktivieren, um die leitende Verbindung zwischen den leitenden Wegbereichen zu bilden.

2. Verbindungsstruktur in Kombination mit den leitenden Wegbereichen, nach Anspruch 1, bei der der Metallfilm wenigstens eines der Metalle Molybdän, Tantal, Wolfram, Titan, Platin umfaßt.

3. Verbindungsstruktur in Kombination mit den leitenden Wegen nach Anspruch 1 oder 2, derart, daß das Metallsilicid (22), das bei Aktivierung der Verbindungsstruktur gebildet wird, einen Widerstand von $10^2$ $\Omega$cm oder weniger hat.

4. Verbindungsstruktur in Kombination mit den leitenden Wegen nach einem der vorhergehenden Ansprüche, bei der die isolierende Siliziumschicht (17) eine nichtdotierte Polysiliziumschicht ist.

5. Verbindungsstruktur in Verbindung mit den leitenden Wegbereichen nach einem der Ansprüche 1, 2 oder 3, bei der die isolierende Siliziumschicht (17) eine nichtdotierte amorphe Siliziumschicht ist.

6. Verbindungsstruktur in Kombination mit den leitenden Wegbereichen nach einem der vorhergehenden Ansprüche, bei der die isolierende Siliziumschicht (17) einen Widerstand von $10^9$ $\Omega$cm oder mehr hat.

7. Verbindungsstruktur in Kombination mit den leitenden Wegbereichen nach einem der vorhergehenden Ansprüche, die durch Erhitzen durch Bestrahlung mit einem Elektronenstrahl, einem Ionenstrahl oder einem Laserstrahl aktivierbar ist.

8. Verbindungsstruktur in Kombination mit den leitenden Wegbereichen nach Anspruch 7, aktivierbar durch Erhitzen auf eine Temperatur im Bereich von 500°C bis 700°C.

9. Integrierte Schaltung nit elektrisch isolierter Ersatzschaltung, die eine Verbindungsstruktur in Kombination mit den leitenden Wegbereichen nach einem der Ansprüche 1 bis 8 aufweist, die selektiv aktivierbar ist, um eine elektrische Verbindung zu der Ersatzschaltung herzustellen.

## Revendications

1. Structure de jonction dans un circuit intégré, en combinaison avec des régions conductrices (13) dans le circuit intégré, qui sont isolées électriquement les unes des autres, cette structure de jonction pouvant être activée sélectivement pour établir une jonction conductrice entre les régions conductrices; caractérisée en ce que la structure de jonction comporte: une couche d'isolement (17) en silicium hautement résistif recouvrant des parties respectives des régions conductrices (13), et une pellicule métallique (16) sur la couche isolante en silicium, agencée de manière que la couche isolante en silicium puisse réagir chimiquement avec la pellicule métallique pour former un siliciure métallique conducteur quand la structure de jonction est chauffée localement, activant ainsi la structure de junction pour établir la jonction conductrice entre les régions conductrices.

2. Structure de jonction en combinaison avec les régions conductrices, selon la revendication 1, dans laquelle la pellicule métallique contient l'un au moins des métaux comprenant le molybdène, le tantale, le tungstène, le titane, le platine.

3. Structure de jonction en combinaison avec les régions conductrices selon la revendication 1 ou 2, dans laquelle le siliciure métallique (22) formée par l'activation de la structure de jonction a une résistivité de $10^2$ Ohms/cm ou moins.

4. Structure de jonction en combinaison avec les régions conductrices selon l'une quelconque des revendications précédentes, dans laquelle la couche d'isolement en silicium (17) est une couche de polysilicium non dopée.

5. Structure de jonction en combinaison avec les régions conductrices selon la revendication 1, 2 ou 3 dans laquelle la couche isolante en silicium (17) est une couche de silicium amorphe non dopée.

6. Structure de jonction en combinaison avec les régions conductrices selon l'une quelconque des revendications précédentes, dans laquelle la couche d'isolement en silicium (17) a une résistivité de $10^9$ Ohms/cm ou davantage.

7. Structure de jonction en combinaison avec les régions conductrices selon l'une quelconque des revendications précédentes, pouvant être activée par chauffage, par irradiation d'un faisceau électronique, d'un faisceau ionique ou d'un faisceau de laser.

8. Structure de jonction en combinaison avec les régions conductrices selon la revendication 7, pouvant être activée par chauffage à une température dans la plage de 500° à 700°C.

9. Circuit intégré comportant un circuit de réserve isolé électriquement, muni d'une structure de jonction en combinaison avec les régions conductrices selon l'une quelconque des revendications 1 à 8, pouvant être activée sélectivement pour établir une connexion électrique avec le circuit de réserve.

Fig. 1

Fig. 2

Fig. 3

Fig 4

18
12
11

Fig 5

13   14      19  13

12

11

Fig. 6

13      14      13      17

12

11

Fig 7

Fig. 8

Fig. 9